# EUROPEAN PATENT APPLICATION

(11) **EP 4 686 092 A1**
(43) Date of publication of application: **28.01.2026**
(21) Application number: 24306254.4
(22) Date of filing: 24.07.2024
(51) Int. Cl.: H03D 7/14

(54) **SUBHARMONIC MIXER**

(71) Applicant: NXP B.V., 5656 AG Eindhoven (NL); Université de Bordeaux, 33000 Bordeaux (FR); Institut Polytechnique de Bordeaux, 33402 Talence (FR); Centre National de la Recherche Scientifique, 75794 Paris Cedex 16 (FR)
(72) Inventor: Lancon, Leo Lucas, 31023 Toulouse (FR); Taris, Thierry, 31023 Toulouse (FR); Pavao Moreira, Cristian, 31023 Toulouse (FR); Vallee, Higo Albert, 31000 Toulouse (FR)
(74) Representative: Hardingham, Christopher Mark

(57) **Abstract**

The present disclosure relates to a subharmonic mixer including first and second radio frequency (RF) inputs, local oscillator inputs configured and arranged to receive at least a first, second, third, and fourth local oscillator signals having respective first, second, third, and fourth phases and each having a first frequency, first, second, third, and fourth outputs, a first capacitor coupled between the first RF input and a first node, a first switch coupled between the first node and the second RF input and including a first control terminal to receive the first local oscillator signal, a second switch coupled between the first node and the first output and including a second control terminal to receive the fourth local oscillator signal, and a third switch coupled between the first node and the third output and including a third control terminal to receive the second local oscillator signal.

## Description

### TECHNICAL FIELD

Embodiments of the subject matter described herein relate generally to mixer circuitry, such as mixer circuitry for use in automotive radar systems or wireless communications systems.

### BACKGROUND

Mixer circuitry is widely used to shift signals between frequency ranges, typically for purposes of signal transmission or signal processing. Mixer circuitry is commonly used in radio frequency (RF) receivers, such as those used in conventional radar systems and wireless communications systems, such as telecommunications systems.

Automotive radar solutions for advanced driver assistance systems (ADAS) are currently being deployed on a large scale, and are typically implemented as long-range radar (LRR) applications or short-range radar (SRR) applications. Both of these applications typically use frequency modulated continuous wave (FMCW) modulation techniques in order to be able to identify objects in the vicinity of the radar system, such as a vehicle or a pedestrian. Such radar systems typically utilize millimeter wave (mmW) frequencies for transmission and reception or radar signals.

### BRIEF DESCRIPTION OF DRAWINGS

A more complete understanding of the subject matter may be derived by referring to the detailed description and claims when considered in conjunction with the following figures, wherein like reference numbers refer to similar elements throughout the figures. Elements in the figures are illustrated for simplicity and clarity and have not necessarily been drawn to scale. The figures along with the detailed description are incorporated and form part of the specification and serve to further illustrate examples, embodiments and the like, and explain various principles and advantages, in accordance with the present disclosure, wherein:
FIG. 1 shows an illustrative block diagram of a radar system that includes receiver circuitry having a subharmonic mixer, in accordance with various embodiments;
FIG. 2 shows a diagram illustrating circuitry including a subharmonic mixer, such as the subharmonic mixer of FIG. 1, in accordance with various embodiments; and
FIG. 3 shows a circuit diagram illustrating a subharmonic mixer, such as the subharmonic mixer of FIG. 1 or FIG. 2, in accordance with various embodiments.

### DETAILED DESCRIPTION

The following detailed description is merely illustrative in nature and is not intended to limit the embodiments described herein and uses of such embodiments. Furthermore, there is no intention to be bound by any expressed or implied theory presented in the preceding technical field, background, or the following detailed description.

For simplicity and clarity of illustration, the figures illustrate the general manner of construction. Descriptions and details of well-known features and techniques may be omitted from the following detailed description to avoid unnecessarily obscuring the present disclosure. For example, the dimensions of some of the elements or regions in the figures may be exaggerated relative to other elements or regions to help improve understanding of embodiments described herein.

The terms "first," "second," "third," "fourth" and the like in the description and the claims, if any, may be used for distinguishing between similar elements and not necessarily for describing a particular sequential or chronological order. It is to be understood that the terms so used are interchangeable under appropriate circumstances such that the embodiments described herein are, for example, capable of operation in sequences other than those illustrated or otherwise described herein. Furthermore, the terms "comprise," "include," "have" and any variations thereof, are intended to cover non-exclusive inclusions, such that a process, method, article, or apparatus that comprises a list of elements is not necessarily limited to those elements but may include other elements not expressly listed or inherent to such process, method, article, or apparatus. As used herein the terms "approximate," "approximately," "substantial" and "substantially" mean sufficient to accomplish the stated purpose in a practical manner and that minor imperfections, if any, are not significant for the stated purpose.

Along these lines, when used with references to measurable quantities including, but not limited to, dimensions, these terms mean that the quantities are equal to the values stated subject to accepted tolerances of any methods or apparatus chosen to fabricate the described structures or measure the quantities or dimensions described. Directional references such as "top," "bottom," "left," "right," "above," "below," and so forth, unless otherwise stated, are not intended to require any preferred orientation and are made with reference to the orientation of the corresponding figure or figures for purposes of illustration. As used herein, the words "exemplary" and "example" mean "serving as an example, instance, or illustration." Any implementation described herein as exemplary or an example is not necessarily to be construed as preferred or advantageous over other implementations. In addition, certain terms may also be used herein for reference only, and thus are not intended to be limiting.

Herein, elements or nodes or features are sometimes referred to as being "connected" or "coupled" together. As used herein, unless expressly stated otherwise, "connected" means that one element is directly joined to (or directly communicates with) another element in an electrical or non-electrical manner, and not necessarily mechanically. Likewise, unless expressly stated otherwise, "coupled" means that one element is directly or indirectly joined to (or directly or indirectly communicates with) another element in an electrical or non-electrical manner, and not necessarily mechanically. Thus, although the schematic illustrations shown in the figures depict exemplary arrangements of elements, additional intervening elements, devices, features, or components may be present in one or more embodiments of the depicted subject matter.

Various embodiments described herein relate to radar systems, such as automotive radar systems, having receiver circuitry that includes a subharmonic mixer. Herein, a mixer is considered to be a "subharmonic" mixer if it is configured to receive at least one LO signal and an RF input signal, where the LO signal is at or around a harmonic of the frequency of the LO signal, and where the harmonic is greater than 1 (e.g., the RF input signal may be at or around the second harmonic of the LO signal frequency, as a non-limiting example). That is, the frequency of an LO signal received by a subharmonic mixer may be a subharmonic of (i.e., an integral submultiple of) the frequency of the RF input signal.

At least some capacitors of the subharmonic mixer of one or more embodiments described herein may be provided in a "bottom plate mixing" arrangement in combination with corresponding transistors (or other suitable switching mechanisms) and output nodes. In the bottom plate mixing arrangement, such capacitors may each have a top plate coupled to a radio frequency (RF) signal input and a bottom plate coupled to an intermediate node that is coupled to an associated output and baseband capacitor, such that RF signals are down-mixed from the bottom plates of these capacitors.

Conventional radar systems typically includes mixers in the receive path, which require inputs from local oscillator (LO) circuitry of the transmit path where signals provided by the LO circuitry have the same nominal frequency as the radar signals being down-converted by the mixers (i.e., *f_{LO}* = *f_{RF}).* In view of this frequency requirement, mixers used in such conventional radar systems are not subharmonic. Additionally, this frequency requirement typically requires that additional LO frequency multipliers be included in the circuitry of the transmit path, which may undesirably increase the footprint of such conventional radar systems.

In one or more embodiments herein, a system for wireless signal transmission and reception, such as an automotive radar system or a wireless communication system, may include transmitter circuitry and receiver circuitry, where the receiver circuitry includes a subharmonic mixer configured to receive an RF signal from a receive antenna that is coupled to the receiver circuitry and configured to receive one or more LO signals from an LO of the transmitter circuitry (via one or more LO frequency multipliers), where the one or more LO signals are generated (e.g., by an LO frequency multiplier that acts as a frequency quadrupler) based on an initial RF signal (e.g., an RF chirp signal) that is generated by a chirp generator coupled to the transmitter circuitry. The transmitter circuitry may be configured to transmit radar signals at a frequency that is greater than (e.g., at or around twice the frequency of) the one or more LO signals provided to the subharmonic mixer. In this way, reflected signals (i.e., reflections of the transmitted signal, which are reflected by one or more objects in the environment of the radar system) received at the receive antenna may also have a frequency that is greater than (e.g., at or around twice the frequency of) the one or more LO signals provided to the subharmonic mixer, where such reflected signals are provided at one or more RF inputs of the subharmonic mixer.

As a non-limiting example, the subharmonic mixer may receive one or more LO signals each having a frequency at or around 40 GHz at LO inputs of the subharmonic mixer and may receive one or more RF signals (e.g., which may be provided as differential signals) each having a frequency of around 80 GHz at one or more RF inputs of the subharmonic mixer. LO signals provided to the subharmonic mixer from the transmitter circuitry may have respectively different phase offsets. For example, the subharmonic mixer may be configured to receive four LO signals may have phase offsets of 0°, 90°, 180°, and 270°.

In one or more embodiments, the subharmonic mixer may include differential RF inputs coupled to the receive antenna, multiple (e.g., four) LO inputs coupled to an LO of the transmitter circuitry, and differential outputs (e.g., two sets of differential outputs). The subharmonic mixer may include multiple capacitors, each having a top plate coupled to one of the RF inputs and a bottom plate coupled to at least one of (e.g., two of) the outputs of the subharmonic mixer. That is, the subharmonic mixer may include capacitors that are provided a bottom plate mixing arrangement. At each output of the subharmonic mixer, a respective baseband capacitor may be coupled between the output and a ground or reference node.

In one or more embodiments, the subharmonic mixer may include multiple (e.g., four) legs, with each leg including at least a capacitor coupled between one of the RF inputs and an intermediate node, a first transistor coupled between another one of the RF inputs and the intermediate node, a second transistor coupled between the intermediate node and one of the outputs, and a third transistor coupled between the intermediate node and another of the outputs. A fourth transistor may be coupled in parallel with the first transistor. The first, second, third, and fourth transistor may each receive respectively different LO signals having respectively different phases (e.g., with nominal phase offsets of 0°, 90°, 180°, and 270°).

The bottom plate mixing arrangement of the subharmonic mixer may advantageously provide improved voltage gain, reduced noise, and better compression, in comparison with conventional systems that do not use bottom plate mixing. The subharmonic operation of the subharmonic mixer may advantageously improve efficiency and reduce the number of frequency multipliers required to be included in the transmitter circuitry, thereby reducing overall footprint, in comparison with conventional systems that do not use subharmonic mixers. In one or more embodiments, differential outputs of the subharmonic mixer may be recombined to provide improved voltage gain.

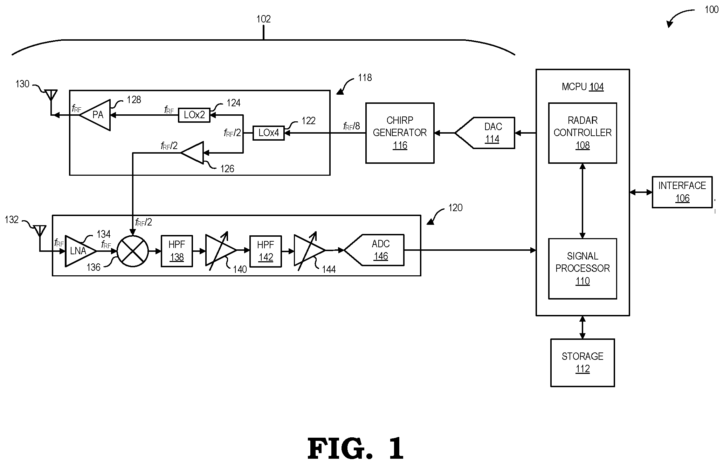

FIG. 1 shows an illustrative diagram of a radar system 100 which includes a radar device 102 (sometimes referred to herein as "radar communication circuitry 102" or "radar front-end circuitry 102") that is connected to a radar microcontroller and processing unit (MCPU) 104, where the MCPU 104 may be configured to perform interference suppression of analog-to-digital converter (ADC) samples representing received reflected radar signals. Such interference suppression may be performed prior to range and Doppler compression in accordance with one or more embodiments. In one or more embodiments, the radar system 100 may be a civil automotive radar system implemented in, for example, a civilian vehicle.

While a single set of transmitter circuitry 118 and receiver circuitry 120 are shown in the present example, it should be understood that the radar device 102 may include multiple stets of transmitter circuitry and receiver circuitry. For example, in one or more embodiments, the radar system 100 may be a Multiple-Input Multiple-Output (MIMO) radar system, such as a Linear Frequency Modulation (LFM) MIMO radar system (e.g., an LFM automotive MIMO radar system).

In one or more embodiments, the radar device 102 may include radar front-end hardware. In one or more embodiments, the radar device 102 may be embodied as a line-replaceable unit (LRU) or modular component that is designed to be replaced quickly at an operating location. Similarly, the radar MCPU 104 may be embodied as a line-replaceable unit (LRU) or modular component. Although a single or mono-static radar devices are shown, it will be appreciated that additional distributed radar devices may be used to form a distributed or multi-static radar. In addition, the depicted radar system 100 may be implemented in integrated circuit form with the radar device 102 and the radar MCPU 104 formed on separate integrated circuits (chips) or on a single chip, depending on the application. In accordance with various embodiments, the radar system 100 may be implemented as part of an automotive system in conjunction with an Advanced Driver Assistance System (ADAS).

The radar device 102 includes a transmitting antenna element 130 (sometimes referred to herein as "transmit antenna 130") and a receiving antenna element 132 (sometimes referred to herein as "receive antenna 132") connected, respectively, to radio frequency (RF) transmitter (TX) circuitry 118 and RF receiver (RX) circuitry 120.

The radar device 102 includes a chirp generator 116 (sometimes referred to herein as "signal generator 116"), which is configured to supply input signals, such as chirp input signals, to the transmitter circuitry 118. To this end, the chirp generator 116 is configured to receive input program and control signals, including, as non-limiting examples, one or more reference local oscillator (LO) signals, a chirp start trigger signal, and program control signals, from the MCPU 104 via a digital-to-analog converter (DAC) 114. The chirp generator 116 is configured to generate chirp signals and send the chirp signals to the transmitter circuitry 118 for transmission via the transmitting antenna element 130. In one or more embodiments, the transmitter circuitry 118 may include an RF conditioning module (not shown) that is configured to filter phase-coded chirp signals. The transmitter circuitry 118 includes local oscillator circuitry, which includes LO frequency multipliers 122 and 124 and a buffer 126. In the present example, the LO frequency multipliers 122 and 124 and the buffer 126 may be considered to be or to be included in "LO circuitry" of the transmitter circuitry 118. The LO frequency multiplier 122 may be coupled between the chirp generator 116 and the LO frequency multiplier 124, and may be configured to quadruple the frequency of one or more signals output by the chirp generator 116. The LO frequency multiplier 124 may be coupled between the output of the LO frequency multiplier 122 and the input of a power amplifier 128 of the transmitter circuitry 118, and may be configured to double the frequency of one or more signals output by the LO frequency multiplier 122.The buffer 126 may be coupled between the output of the LO frequency multiplier 122 and one or more inputs of a subharmonic mixer 136 of the receiver circuitry 120, and may be configured to provide isolation therebetween. As a non-limiting example, the chirp generator 116 may generate a signal having a frequency *f*_{RF}/8 (i.e., one-eighth of a desired output signal frequency *f*_{RF}), the LO frequency multiplier 122 may be configured to quadruple the frequency of signals output by the chirp generator 116 such that signals output by the LO frequency multiplier 122 have a frequency of *f*_{RF}/2 (.e., half of the desired output signal frequency *f*_{RF}), the LO frequency multiplier 124 may be configured to double the frequency of signals output by the LO frequency multiplier 122 such that signals output by the LO frequency multiplier 124 have a frequency of *f*_{RF}. In such an example, signals received by the buffer 126 from the LO frequency multiplier 122 and output by the buffer 126 to the subharmonic mixer 136 have the frequency *f*_{RF}/2, and signals received by and output by the power amplifier 128 and subsequently transmitted via the transmit antenna 130 have the frequency *f*_{RF}. Signals output via the transmit antenna 130, when reflected by objects in the environment of the radar system 100, are received by the receiver circuitry 120 via the receive antenna 132 and passed, via a low noise amplifier (LNA) 134 of the receiver circuitry 120, to one or more RF inputs of the subharmonic mixer 136. In this way, LO signals received at LO inputs of the subharmonic mixer 136 of the receiver circuitry 120 have a frequency that is at or around half the frequency of reflected radar signals that are received via the receive antenna 132 and provided at RF inputs of the subharmonic mixer 136, as will be described in more detail below.

The power amplifier 128 may be configured to amplify the chirp signals before they are provided to and transmitted via the transmit antenna 130. Herein, a transmitted chirp signal is sometimes referred to as a "transmit signal" or a" transmitted radar signal".

The radar signal transmitted by the transmitter circuitry 118 and transmit antenna 130 be reflected by an object in an environment of the radar system 100, and part of the reflected radar signal, sometimes referred to herein as a "return signal", "reflection", or "reflected radar signal," is received by the receive antenna 132 at the radar device 102. At the receiver circuitry 120, the reflected radar signal is amplified by the LNA 134 and then fed to a subharmonic mixer 136. The subharmonic mixer 136 is configured to mix the reflected radar signal (e.g., having the frequency *f*_{RF}) with the LO signal provided by the LO frequency multiplier 122 via the buffer 126 (e.g., having the frequency *f*_{RF}/2). The resulting intermediate frequency (IF) signal is fed to a high-pass filter (HPF) 138, which applies high pass filtering of the IF signal. The resulting filtered signal is fed to a variable gain amplifier 140, which amplifies the filtered signal before providing it to a second HPF 142, which performs additional high pass filtering of the signal. The second HPF 142 then passes this re-filtered signal to a second variable gain amplifier 144, which amplifies the re-filtered signal before providing it to an analog-to-digital converter (ADC) 146. The ADC 146 performs analog-to-digital conversion of the signal output by the variable gain amplifier 144 before providing the resulting digital signal to the signal processor 110 of the MCPU 104. In this way, the receiver circuitry 120 compresses the reflected signal into a sinusoidal tone whose frequency corresponds to the round-trip delay of the reflected signal.

In the radar system 100, the MCPU 104 may be connected and configured to supply input control signals to the radar device 102 and to receive therefrom digital output signals generated by the receiver circuitry 120. In one or more embodiments, the MCPU 104 includes a radar controller 108 and a signal processor 110, either or both of which may be embodied as a microcontroller unit or other processing unit. The MCPU 104, the radar controller 108, and the signal processor 110 each include or are implemented by computer processing circuitry, in accordance with various embodiments. The radar controller 108 can receive data from the radar device 102 (e.g., from the receiver circuitry 120) and can control radar parameters of the radar device 102, such as frequency band, length of each radar frame, and the like via the DAC 114. For example, the DAC 114 may be used to adjust the radar chirp signals output from the chirp generator 116 included in the radar device 102. The signal processor 110 may be configured and arranged for signal processing tasks such as, but not limited to, target object identification, interference mitigation, computation of the distance or range to a target object, computation of the radial velocity of a target object, and computation of the AoA of signals reflected by a target object, and the like. Herein, the term "AoA" or "Angle-of-Arrival" refers to the angle of a reflected signal (e.g., a radar signal) incident on an antenna array. The signal processor 110 can provide calculated values associated with such computations to a storage 112 and/or to other systems via an interface 106.

The interface 106 can enable the MCPU 104 to communicate with other systems over local and wide area networks, the internet, automotive communication buses, and/or other kinds of wired or wireless communication systems, as non-limiting examples. In one or more embodiments, the MCPU 104 can provide the calculated values over the interface 106 to other systems, such as a radar-camera-lidar fusion system; an automated driving assistance system including parking, braking, or lane-change assistance features; and the like. The storage 112 can be used to store instructions for the MCPU 104, received data from the radar device 102, calculated values from the signal processor 110, and the like. Storage 112 can be any suitable storage medium, such as a volatile or non-volatile computer-readable memory.

To control the transmitter circuitry 118, the radar controller 108 may, for example, be configured to generate transmitter input signals, such as program, control trigger, reference LO signals, calibration signals, frequency spectrum shaping signals (such as ramp generation in the case of Frequency-Modulated Continuous Wave (FMCW) radar). The radar controller 108 may, for example, be configured to receive data signals, sensor signals, and/or register programming or state machine signals for RF (radio frequency) circuit enablement sequences.

At the receiver circuitry 120, digital output signals are generated from target return signals for digital processing by the signal processor 110 to construct and accumulate multiple-input multiple-output (MIMO) array vector outputs forming a MIMO aperture for use in computing plots or maps for AoA estimation and target object tracks. In one or more embodiments, the signal processor 110 may perform an interference suppression process on the digital output signals before processing the resultant interference-suppressed signals using one or more fast Fourier transform (FFT) modules or Discrete Fourier Transform (DFT) modules, such as a fast-time (range) FFT module.

As a non-limiting example, processing by such modules of the signal processor 110 may generate a range chirp antenna cube (RCAC) and a slow-time (Doppler) FFT module which generates a range-Doppler antenna cube (RDAC) (e.g., including range-Doppler response maps for each RX antenna). The signal processor 110 may then perform Constant False Alarm Rate (CFAR) detection on the range-Doppler antenna cube to detect peaks in the RDAC. The signal processor 110 may further process the RDAC based on the detected peaks to construct a MIMO array vector which the signal processor 110 then processes to perform AoA estimation and target object tracking. The MCPU 104 may then output the resulting target tracks (e.g., via the interface 106) to other automotive computing or user interfacing devices for further processing or display.

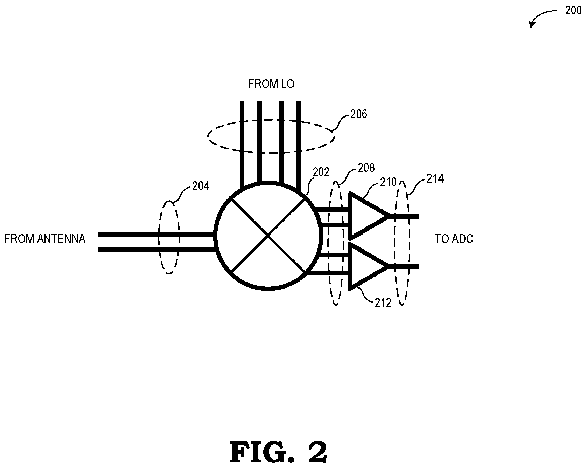

FIG. 2 shows an illustrative example of a subharmonic mixer circuitry 200 including a subharmonic mixer 202. The subharmonic mixer 202 may correspond to an example embodiment of the subharmonic mixer 136 of FIG. 1, as a non-limiting example. As shown, the subharmonic mixer 202 includes RF inputs 204, LO inputs 206, and outputs 208. Differential amplifiers 210 and 212 may be coupled to respective sets of differential outputs of the outputs 208, and may be configured to recombine such differential outputs. The outputs 214 of the differential amplifiers 210 and 212 may be provided to an ADC (e.g., the ADC 146 of FIG. 1) via one or more filters and one or more amplifiers (e.g., high pass filters 138, 142 and variable gain amplifiers 140, 144 of FIG. 1).

While, in the present example, differential amplifiers are used to recombine the outputs of the subharmonic mixer 202, it should be understood that this is intended to be illustrative and non-limiting. In one or more other embodiments, for example, other suitable recombination circuitry may be implemented to recombine the outputs of the subharmonic mixer 202.

The subharmonic mixer 202 may receive a pair of differential RF input signals from an antenna (e.g., the receive antenna 132 of FIG. 1) at the RF inputs 204. In one or more embodiments, the subharmonic mixer 202 may receive the pair of differential input signals from the antenna via a low noise amplifier (e.g., the low noise amplifier 134 of FIG. 1). The subharmonic mixer 202 may receive, at the LO inputs 206, four LO signals from an LO frequency multiplier (e.g., the LO frequency multiplier 122 of FIG. 1) of transmitter circuitry (e.g., transmitter circuitry 118 of FIG. 1) of a radar system that includes the subharmonic mixer 202. In one or more embodiments, the LO signals provided at the LO inputs 206 may have respectively different phases. In one or more embodiments, the LO signals provided at the LO inputs 206 include a first LO signal having a first phase, a second LO signal having a second phase, a third LO signal having a third phase, and a fourth LO signal having a fourth phase. In one or more embodiments, the first phase may be, nominally and considering a single direction of phase offset, 90° offset from the second phase, 180° offset from the third phase, and 270° offset from the fourth phase. For example, phases of each of the LO signals may be defined as offsets relative to the first phase, such that the first phase may be considered to have a 0° phase offset, the second phase may be considered to have a 90° phase offset, the third phase may be considered to have a 180° phase offset, and the fourth phase may be considered to have a 270° phase offset.

It should be understood that, while the subharmonic mixer 202 is described as receiving LO signals with four different phases in one or more embodiments, the number of LO signal phases used may change in one or more other embodiments in which IQ mixing is used (e.g., which may double the required number of phases) and/or in which the RF input signal is a different frequency multiple of the LO signals. For example, in one or more embodiments in which the RF input signal frequency is four times the LO signal frequency, LO signals with 8 different phases may be provided at the LO inputs 206. As another example, in one or more embodiments in which the RF input signal frequency is eight times the LO signal frequency, LO signals with 16 different phases may be provided at the LO inputs 206.

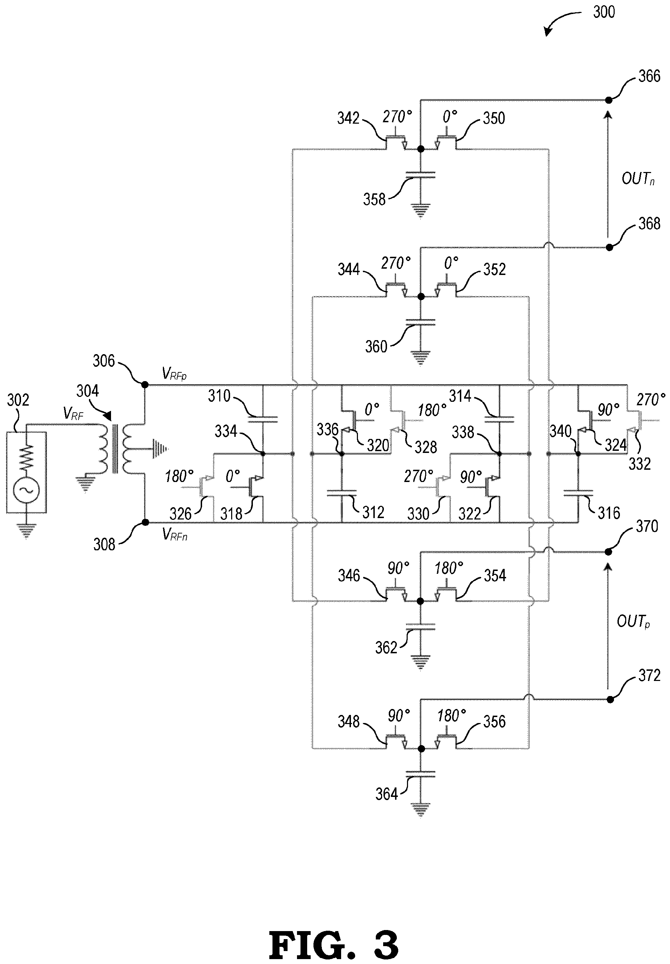

The LO signals may be provided at the gates of various transistors of the subharmonic mixer 202, with one or more embodiments of such an arrangement being shown and described in more detail below in connection with FIG. 3.

The RF signals provided at the RF inputs 204 may each have a frequency at or around *f*_{RF} (e.g., at or around 80 GHz, as a non-limiting example). The LO signals provided at the LO inputs 206 may each have a frequency that is less than *f*_{RF}. For example, the LO signals may each have a frequency that is at or around *f*_{RF}/2 (e.g., at or around 40 GHz, as a non-limiting example). The subharmonic mixer may be configured to generate IF signals (e.g., baseband signals with frequencies less than 10 MHz, provided at the outputs 208, via down-conversion of the received RF signals based on the LO signals. The outputs of the amplifiers 210 and 212 may be a pair of differential IF signals.

FIG. 3 shows an illustrative circuit diagram of a subharmonic mixer 300. The subharmonic mixer 300 may be provided in a bottom plate mixing arrangement, as shown. The subharmonic mixer 300 may correspond to an example embodiment of the subharmonic mixer 136 of FIG. 1, as a non-limiting example. The subharmonic mixer 300 may correspond to an example embodiment of the subharmonic mixer 202 of FIG. 2, as a non-limiting example.

The subharmonic mixer 300 may include first and second input nodes 306 and 308 (sometimes referred to herein as "RF inputs 306 and 308") and first, second, third, and fourth outputs nodes 366, 368, 370, and 372 (sometimes referred to herein as "outputs 366, 368, 370, and 372). The subharmonic mixer 300 may include capacitors 310, 312, 314, and 316, transistors 318, 320, 322, 324, 326, 328, 330, 332, 342, 344, 346, 348, 350, 352, 354, and 356 (each having respective gate terminals, drain terminals, and source terminals), and baseband capacitors 358, 360, 362, and 364. LO signals may be provided (e.g., by the LO frequency multiplier 122 of FIG. 1) at gate terminals (sometimes referred to herein as "control terminals") of the transistors 318, 320, 322, 324, 326, 328, 330, 332, 342, 344, 346, 348, 350, 352, 354, and 356, and the relative nominal phase offset of each LO signal is shown at the corresponding gate terminals. The gate terminals of these transistors may be considered "LO inputs" (e.g., such as the LO inputs 206 of FIG. 2) that are configured and arranged receive such LO signals.

While the subharmonic mixer 300 is shown to include transistors (e.g., transistors 318, 320, 322, 324, 326, 328, 330, 332, 342, 344, 346, 348, 350, 352, 354, and 356), such as nMOS transistors, that are used as switching elements in the present example, it should be understood that this is intended to be illustrative and non-limiting. For example, in one or more other embodiments, one or more electric switches or other suitable switching mechanisms other than individual transistors may be used in place of any of the transistors of the subharmonic mixer 300 when implementing the subharmonic mixer 300. Such switches would still receive associated LO signals at their respective control terminals, in one or more such other embodiments.

As shown, the RF inputs 306 and 308 are coupled to an antenna 302 via a balun 304. A single ended RF signal V_{RF} may be provided from the antenna 302 to the balun 304. The balun 304 may output a pair of differential RF signals V_{RFp} and V_{RFn}, which the balun 304 provides to the RF inputs 306 and 308, respectively. In the present example, the antenna 302 is represented as a voltage source and resistance coupled in series. It should be understood that, while not shown in the present example, one or more other components (e.g., a low noise amplifier, such as the low noise amplifier 134 of FIG. 1) may additionally be coupled between the antenna 302 and the RF inputs 306 and 308 in accordance with one or more other embodiments.

The subharmonic mixer 300 may include first, second, third, and fourth circuit legs, each coupled between the RF inputs 306 and 308 and a pair of outputs (e.g., outputs 366 and 370 or outputs 368 and 372). Each circuit leg may include capacitor coupled in series with at least one transistor, where an intermediate node beteween the transistor and the capacitor is coupled to a corresponding pair of outputs through respective additional transistors.

For example, the first circuit leg includes a capacitor 310 coupled between the RF input 306 and an intermediate node 334, a transistor 318 coupled between the RF input 308 and the intermediate node 334, a transistor 326 coupled between the RF input 308 and the intermediate node 334 (i.e., coupled in parallel with the transistor 318). The first circuit leg includes a transistor 342 coupled between the intermediate node 334 and the first output 366. The first circuit leg includes a transistor 346 coupled between the intermediate node 334 and the third output 370.

In one or more embodiments, in the first circuit leg, the transistor 318 may be configured and arranged to receive, at its gate terminal, a first LO signal having a first phase, the transistor 346 may be configured and arranged to receive, at its gate terminal, a second LO signal having a second phase, the transistor 326 may be configured and arranged to receive, at its gate terminal, a third LO signal having a third phase, and the transistor 342 may be configured and arranged to receive, at its gate terminal, a fourth LO signal having a fourth phase. In one or more embodiments, the first phase may be, nominally and considering a single direction of phase offset, 90° offset from the second phase, 180° offset from the third phase, and 270° offset from the fourth phase. For example, phases of each of the LO signals may be defined as offsets relative to the first phase, such that the first phase may be considered to have a 0° phase offset, the second phase may be considered to have a 90° phase offset, the third phase may be considered to have a 180° phase offset, and the fourth phase may be considered to have a 270° phase offset.

The RF input signals V_{RFp} and V_{RFn} may each have a frequency of *f*_{RF} (e.g., at or around 80 GHz in one or more embodiments). Each of the first, second, third, and fourth LO signals may each have a frequency at or around (e.g., within +/- 5% of)*f*_{RF}/2 (e.g., at or around 40 GHz in one or more embodiments). That is, the frequency of the LO input signals may be a subharmonic of the frequency of the RF input signals.

For example, the second circuit leg includes a capacitor 312 coupled between the RF input 308 and an intermediate node 336, a transistor 320 coupled between the RF input 306 and the intermediate node 336, a transistor 328 coupled between the RF input 306 and the intermediate node 336 (i.e., coupled in parallel with the transistor 320). The second circuit leg includes a transistor 344 coupled between the intermediate node 336 and the second output 368. The second circuit leg includes a transistor 348 coupled between the intermediate node 336 and the fourth output 372.

In one or more embodiments, in the second circuit leg, the transistor 320 may be configured and arranged to receive, at its gate terminal, the first LO signal having the first phase, the transistor 348 may be configured and arranged to receive, at its gate terminal, the second LO signal having the second phase, the transistor 328 may be configured and arranged to receive, at its gate terminal, the third LO signal having the third phase, and the transistor 344 may be configured and arranged to receive, at its gate terminal, the fourth LO signal having the fourth phase.

For example, the third circuit leg includes a capacitor 314 coupled between the RF input 306 and an intermediate node 338, a transistor 322 coupled between the RF input 308 and the intermediate node 338, a transistor 330 coupled between the RF input 308 and the intermediate node 338 (i.e., coupled in parallel with the transistor 322). The third circuit leg includes a transistor 352 coupled between the intermediate node 338 and the second output 368. The third circuit leg includes a transistor 356 coupled between the intermediate node 338 and the fourth output 372.

In one or more embodiments, in the third circuit leg, the transistor 352 may be configured and arranged to receive, at its gate terminal, the first LO signal having the first phase, the transistor 322 may be configured and arranged to receive, at its gate terminal, the second LO signal having the second phase, the transistor 356 may be configured and arranged to receive, at its gate terminal, the third LO signal having the third phase, and the transistor 330 may be configured and arranged to receive, at its gate terminal, the fourth LO signal having the fourth phase.

For example, the fourth circuit leg includes a capacitor 316 coupled between the RF input 308 and an intermediate node 340, a transistor 324 coupled between the RF input 306 and the intermediate node 340, a transistor 332 coupled between the RF input 306 and the intermediate node 340 (i.e., coupled in parallel with the transistor 324). The fourth circuit leg includes a transistor 350 coupled between the intermediate node 340 and the first output 366. The fourth circuit leg includes a transistor 354 coupled between the intermediate node 340 and the third output 370.

In one or more embodiments, in the fourth circuit leg, the transistor 350 may be configured and arranged to receive, at its gate terminal, the first LO signal having the first phase, the transistor 324 may be configured and arranged to receive, at its gate terminal, the second LO signal having the second phase, the transistor 354 may be configured and arranged to receive, at its gate terminal, the third LO signal having the third phase, and the transistor 332 may be configured and arranged to receive, at its gate terminal, the fourth LO signal having the fourth phase.

A respective baseband capacitor may be coupled to each output of the subharmonic mixer 300. For example, the baseband capacitor 358 is coupled between the first output 366 and a ground or reference node. The baseband capacitor 360 is coupled between the second output 368 and a ground or reference node. The baseband capacitor 362 is coupled between the third output 370 and a ground or reference node. The baseband capacitor 364 is coupled between the fourth output 372 and a ground or reference node.

In one or more embodiments, the subharmonic mixer 300 is configured to produce a first pair of differential output signals at the first and second outputs 366 and 368 and to produce a second pair of differential output signals at the third and fourth outputs 370 and 372. In one or more embodiments, recombination circuitry (e.g., differential amplifiers, such as the differential amplifiers 210 and 212 of FIG. 2) may be coupled to the outputs 366, 366, 370, and 372. Such recombination circuitry may be configured to recombine the first pair of differential output signals to produce a first single ended output signal *OUTₙ* and to recombine the second pair of differential output signals to produce a second single ended output signal *OUTₚ.* In one or more such embodiments, the output signals *OUTₙ* and *OUTₚ* may form a differential signal pair. Recombining the outputs of the subharmonic mixer 300 in accordance with one or more such embodiments may advantageously improve voltage gain.

By driving the subharmonic mixer 300 with LO signals at a frequency that is a subharmonic of the frequency of the RF input signals, the LO circuitry (e.g., in the transmitter circuitry 118 of FIG. 1, including one or more LO frequency multipliers, buffers, or the like, as a non-limiting example) required to drive the subharmonic mixer may be advantageously reduced in complexity. For example, for embodiments in which the subharmonic mixer 300 is driven with LO signals at half the frequency of the RF input signals, the LO circuitry used to drive the subharmonic mixer 300 may require one less frequency doubler than would otherwise be needed in a subharmonic mixer that required LO signals to be at the same frequency as the RF input signals. This reduction in complexity of LO circuitry used to drive the subharmonic mixer 300 may desirably result in improvements (e.g., reductions) in circuit size and power consumption of systems utilizing the subharmonic mixer 300.

While subharmonic mixers described herein (e.g., the subharmonic mixers 136, 202, 300 of FIGS. 1, 2, and 3) are sometimes described as being implemented as part of a radar system, this is intended to be illustrative and non-limiting. For example, in various other embodiments, subharmonic mixers described herein may be used in other systems having wireless receiver circuitry, such as telecommunications systems or other suitable wireless communications systems.

Various exemplary embodiments are presented below. Some simplifications and omissions may be made in the following examples, which are intended to highlight and introduce some aspects of the various exemplary embodiments, without limiting the scope.

In an example embodiment, a subharmonic mixer includes first and second radio frequency (RF) inputs, a plurality of local oscillator inputs configured and arranged to receive at least a first local oscillator signal having a first frequency and a first phase, a second local oscillator signal having the first frequency and a second phase, a third local oscillator signal having the first frequency and a third phase, and a fourth local oscillator signal having the first frequency and a fourth phase, first, second, third, and fourth outputs, a first capacitor coupled between the first RF input and a first node, a first switch coupled between the first node and the second RF input and including a first control terminal configured and arranged to receive the first local oscillator signal, a second switch coupled between the first node and the first output and including a second control terminal configured and arranged to receive the fourth local oscillator signal, and a third switch coupled between the first node and the third output and including a third control terminal configured and arranged to receive the second local oscillator signal.

In one or more embodiments, the first phase is nominally 90 degrees offset from the second phase and the second phase is nominally 180 degrees offset from the fourth phase.

In one or more embodiments, the subharmonic mixer is configured and arranged to receive RF signals, each having a second frequency, at the first and second RF inputs, and the first frequency is less than the second frequency.

In one or more embodiments, the first frequency is nominally half the second frequency.

In one or more embodiments, the subharmonic mixer further includes a second capacitor coupled between the second RF input and a second node, a fourth switch coupled between the second node and the first RF input and including a fourth control terminal configured and arranged to receive the first local oscillator signal, a fifth switch coupled between the second node and the second output and including a fifth control terminal configured and arranged to receive the fourth local oscillator signal, and a sixth switch coupled between the second node and the fourth output and including a sixth control terminal configured and arranged to receive the second local oscillator signal.

In one or more embodiments, the subharmonic mixer further includes a third capacitor coupled between the first RF input and a third node, a seventh switch coupled between the third node and the second RF input and including a seventh control terminal configured and arranged to receive the second local oscillator signal, an eighth switch coupled between the third node and the second output and including an eighth control terminal configured and arranged to receive the first local oscillator signal, and a ninth switch coupled between the third node and the fourth output and including a ninth control terminal configured and arranged to receive the third local oscillator signal.

In one or more embodiments, the subharmonic mixer further includes a fourth capacitor coupled between the second RF input and a fourth node, a tenth switch coupled between the fourth node and the first RF input and including a tenth control terminal configured and arranged to receive the second local oscillator signal, an eleventh switch coupled between the fourth node and the first output and including an eleventh control terminal configured and arranged to receive the first local oscillator signal, and a twelfth switch coupled between the fourth node and the third output and including a twelfth control terminal configured and arranged to receive the third local oscillator signal.

In one or more embodiments, the subharmonic mixer further includes a thirteenth switch coupled in parallel with the first switch and including a thirteenth control terminal configured and arranged to receive the third local oscillator signal, a fourteenth switch coupled in parallel with the fourth switch and including a fourteenth control terminal configured and arranged to receive the third local oscillator signal, a fifteenth switch coupled in parallel with the seventh switch and including a fifteenth control terminal configured and arranged to receive the fourth local oscillator signal, and a sixteenth switch coupled in parallel with the tenth switch and including a sixteenth control terminal configured and arranged to receive the fourth local oscillator signal.

In one or more embodiments, the subharmonic mixer further includes a plurality of baseband capacitors, each coupled between a reference node a respective output of the first, second, third, and fourth outputs.

In one or more embodiments, the first and second RF inputs are configured and arranged to receive first and second differential RF inputs signals.

In an example embodiment, a system includes transmitter circuitry and receiver circuitry. The transmitter circuitry includes a signal generator configured to generate a signal, and local oscillator circuitry coupled to the signal generator and configured to generate, based on the signal, a first local oscillator signal having a first frequency and a first phase, a second local oscillator signal having the first frequency and a second phase, a third local oscillator signal having the first frequency and a third phase, and a fourth local oscillator signal having the first frequency and a fourth phase. The receiver circuitry includes an antenna, and a subharmonic mixer. The subharmonic mixer includes first and second inputs coupled to the antenna, first, second, third, and fourth outputs, a first capacitor coupled between the first input and a first node, a first transistor coupled between the first node and the second input and including a first control terminal configured and arranged to receive the first local oscillator signal from the local oscillator circuitry,

a second transistor coupled between the first node and the first output and including a second control terminal configured and arranged to receive the fourth local oscillator signal from the local oscillator circuitry, and a third transistor coupled between the first node and the third output and including a third control terminal configured and arranged to receive the second local oscillator signal from the local oscillator circuitry.

In one or more embodiments, the first phase is nominally 90 degrees offset from the second phase and the second phase is nominally 180 degrees offset from the fourth phase.

In one or more embodiments, the transmitter circuitry is configured to transmit radar signals, each at a second frequency, based on signals generated by the signal generator, and the first frequency is less than the second frequency.

In one or more embodiments, the first and second inputs are configured and arranged to receive differential RF inputs signals having the second frequency and corresponding to reflections of the radar signals transmitted by the transmitter circuitry, and the reflections are received at the antenna of the receiver circuitry.

In one or more embodiments, the first frequency is nominally half the second frequency.

In one or more embodiments, subharmonic mixer further includes a second capacitor coupled between the second input and a second node, a fourth transistor coupled between the second node and the first input and including a fourth control terminal configured and arranged to receive the first local oscillator signal from the local oscillator circuitry, a fifth transistor coupled between the second node and the second output and including a fifth control terminal configured and arranged to receive the fourth local oscillator signal from the local oscillator circuitry, and a sixth transistor coupled between the second node and the fourth output and including a sixth control terminal configured and arranged to receive the second local oscillator signal from the local oscillator circuitry.

In one or more embodiments, the subharmonic mixer further includes a third capacitor coupled between the first input and a third node, a seventh transistor coupled between the third node and the second input and including a seventh control terminal configured and arranged to receive the second local oscillator signal from the local oscillator circuitry, an eighth transistor coupled between the third node and the second output and including an eighth control terminal configured and arranged to receive the first local oscillator signal from the local oscillator circuitry, and a ninth transistor coupled between the third node and the fourth output and including a ninth control terminal configured and arranged to receive the third local oscillator signal from the local oscillator circuitry.

In one or more embodiments, the subharmonic mixer further includes a fourth capacitor coupled between the second input and a fourth node, a tenth transistor coupled between the fourth node and the first input and including a tenth control terminal configured and arranged to receive the second local oscillator signal from the local oscillator circuitry, an eleventh transistor coupled between the fourth node and the first output and including an eleventh control terminal configured and arranged to receive the first local oscillator signal from the local oscillator circuitry, and
a twelfth transistor coupled between the fourth node and the third output and including a twelfth control terminal configured and arranged to receive the third local oscillator signal from the local oscillator circuitry.

In one or more embodiments, the subharmonic mixer further includes a thirteenth transistor coupled in parallel with the first transistor and including a thirteenth control terminal configured and arranged to receive the third local oscillator signal from the local oscillator circuitry, a fourteenth transistor coupled in parallel with the fourth transistor and including a fourteenth control terminal configured and arranged to receive the third local oscillator signal from the local oscillator circuitry, a fifteenth transistor coupled in parallel with the seventh transistor and including a fifteenth control terminal configured and arranged to receive the fourth local oscillator signal from the local oscillator circuitry, and a sixteenth transistor coupled in parallel with the tenth transistor and including a sixteenth control terminal configured and arranged to receive the fourth local oscillator signal from the local oscillator circuitry.

In one or more embodiments, the subharmonic mixer further includes a plurality of baseband capacitors, each coupled between a reference node a respective output of the first, second, third, and fourth outputs.

It should be noted that at least some of the operations described herein may be implemented using software instructions stored on a computer useable storage medium for execution by a computer. As an example, an embodiment of a computer program product includes a computer useable storage medium to store a computer readable program. The computer-useable or computer-readable storage medium can be an electronic, magnetic, optical, electromagnetic, infrared, or semiconductor system (or apparatus or device). Examples of non-transitory computer-useable and computer-readable storage media include a semiconductor or solid-state memory, magnetic tape, a removable computer diskette, a random-access memory (RAM), a read-only memory (ROM), a rigid magnetic disk, and an optical disk.

Alternatively, embodiments herein may be implemented entirely in hardware or in an implementation containing both hardware and software elements. In embodiments which use software, the software may include but is not limited to firmware, resident software, microcode, or other suitable software.

As used herein the terms "circuit" and "circuitry," including the term "processing circuitry" and related terminology means any suitable combination(s) of analog or digital circuit elements, hardware, firmware, software, and the like; including but not limited to, application-specific integrated circuits (ASICs), field programmable gate arrays (FPGAs), microcontrollers, and microprocessors. It will be understood that the term "circuitry" encompasses nonvolatile and volatile memory devices including, but not limited to random access memory (RAM), read-only memory (ROM), and the like, which can be implemented using any suitable devices, such as SRAM, DRAM, or magnetic storage devices as non-limiting examples. Along these lines it will be understood that references to a "processor" or "processing circuitry" can include devices in which general purpose computing devices includes or is otherwise coupled to memory which stores machine-readable instructions configured to cause the processing circuitry to perform the described actions. Such instructions can be stored as instructions in a high level programming language that is readable by human beings which are that are interpreted or compiled into object code or machine language, or they may be stored directly in a low-level language such as object code or machine language or another suitable representation, as nonlimiting examples.

It will be further understood that, unless explicitly stated otherwise, that features such as processing circuitry, memory, and related circuitry and devices can be implemented by any suitable combinations of one or more localized devices including, but not limiting to distributed systems formed by multiple distinct devices in communication with each other via direct electrical communication connections, wireless communication connections, and via public or private communication networks including the Internet. It will further be understood processing circuitry and related devices may be implemented by one or more physical machines or by virtual machines including, but not limited to, virtualized computing environments provided within a "cloud" computing environment or other virtualization systems.

While at least one exemplary embodiment has been presented in the foregoing detailed description, it should be appreciated that a vast number of variations exist. It should also be appreciated that exemplary embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. A subharmonic mixer comprising:
first and second radio frequency, RF, inputs;
a plurality of local oscillator inputs configured and arranged to receive at least a first local oscillator signal having a first frequency and a first phase, a second local oscillator signal having the first frequency and a second phase, a third local oscillator signal having the first frequency and a third phase, and a fourth local oscillator signal having the first frequency and a fourth phase;
first, second, third, and fourth outputs;
a first capacitor coupled between the first RF input and a first node;
a first switch coupled between the first node and the second RF input and including a first control terminal configured and arranged to receive the first local oscillator signal;
a second switch coupled between the first node and the first output and including a second control terminal configured and arranged to receive the fourth local oscillator signal; and
a third switch coupled between the first node and the third output and including a third control terminal configured and arranged to receive the second local oscillator signal.

2. The subharmonic mixer of claim 1, wherein the first phase is nominally 90 degrees offset from the second phase and the second phase is nominally 180 degrees offset from the fourth phase.

3. The subharmonic mixer of claim 2, wherein the subharmonic mixer is configured and arranged to receive RF signals, each having a second frequency, at the first and second RF inputs, wherein the first frequency is less than the second frequency.

4. The subharmonic mixer of claim 3, wherein the first frequency is nominally half the second frequency.

5. The subharmonic mixer of any preceding claim, further comprising:
a second capacitor coupled between the second RF input and a second node;
a fourth switch coupled between the second node and the first RF input and including a fourth control terminal configured and arranged to receive the first local oscillator signal;
a fifth switch coupled between the second node and the second output and including a fifth control terminal configured and arranged to receive the fourth local oscillator signal; and
a sixth switch coupled between the second node and the fourth output and including a sixth control terminal configured and arranged to receive the second local oscillator signal.

6. The subharmonic mixer of claim 5, further comprising:
a third capacitor coupled between the first RF input and a third node;
a seventh switch coupled between the third node and the second RF input and including a seventh control terminal configured and arranged to receive the second local oscillator signal;
an eighth switch coupled between the third node and the second output and including an eighth control terminal configured and arranged to receive the first local oscillator signal; and
a ninth switch coupled between the third node and the fourth output and including a ninth control terminal configured and arranged to receive the third local oscillator signal.

7. The subharmonic mixer of claim 6, further comprising:
a fourth capacitor coupled between the second RF input and a fourth node;
a tenth switch coupled between the fourth node and the first RF input and including a tenth control terminal configured and arranged to receive the second local oscillator signal;
an eleventh switch coupled between the fourth node and the first output and including an eleventh control terminal configured and arranged to receive the first local oscillator signal; and
a twelfth switch coupled between the fourth node and the third output and including a twelfth control terminal configured and arranged to receive the third local oscillator signal.

8. The subharmonic mixer of claim 7, further comprising:
a thirteenth switch coupled in parallel with the first switch and including a thirteenth control terminal configured and arranged to receive the third local oscillator signal;
a fourteenth switch coupled in parallel with the fourth switch and including a fourteenth control terminal configured and arranged to receive the third local oscillator signal;
a fifteenth switch coupled in parallel with the seventh switch and including a fifteenth control terminal configured and arranged to receive the fourth local oscillator signal; and
a sixteenth switch coupled in parallel with the tenth switch and including a sixteenth control terminal configured and arranged to receive the fourth local oscillator signal.

9. The subharmonic mixer of any preceding claim, further comprising:
a plurality of baseband capacitors, each coupled between a reference node a respective output of the first, second, third, and fourth outputs.

10. The subharmonic mixer of any preceding claim, wherein the first and second RF inputs are configured and arranged to receive first and second differential RF inputs signals.

11. A system comprising:
transmitter circuitry comprising:
a signal generator configured to generate a signal; and
local oscillator circuitry coupled to the signal generator and configured to generate, based on the signal, a first local oscillator signal having a first frequency and a first phase, a second local oscillator signal having the first frequency and a second phase, a third local oscillator signal having the first frequency and a third phase, and a fourth local oscillator signal having the first frequency and a fourth phase; and
receiver circuitry comprising:
an antenna; and
a subharmonic mixer as claimed in any preceding claim.

12. The system of claim 11, wherein the first phase is nominally 90 degrees offset from the second phase and the second phase is nominally 180 degrees offset from the fourth phase.

13. The system of claim 12, wherein the transmitter circuitry is configured to transmit radar signals, each at a second frequency, based on signals generated by the signal generator, wherein the first frequency is less than the second frequency.

14. The system of claim 13, wherein the first and second inputs are configured and arranged to receive differential RF inputs signals having the second frequency and corresponding to reflections of the radar signals transmitted by the transmitter circuitry, wherein the reflections are received at the antenna of the receiver circuitry.

15. The system of claim 14, wherein the first frequency is nominally half the second frequency.

## Amended claims

### Amended claims in accordance with Rule 137(2) EPC.

1. A subharmonic mixer (136) comprising:
first and second radio frequency, RF, inputs (204);
a plurality of local oscillator inputs (206) configured and arranged to receive at least a first local oscillator signal having a first frequency and a first phase, a second local oscillator signal having the first frequency and a second phase, a third local oscillator signal having the first frequency and a third phase, and a fourth local oscillator signal having the first frequency and a fourth phase;
first, second, third, and fourth outputs (208);
a first capacitor coupled (310) between the first RF input (306) and a first node (334);
a first switch (318) coupled between the first node (334) and the second RF input (308) and including a first control terminal configured and arranged to receive the first local oscillator signal (0°);
a second switch (342) coupled between the first node (334) and the first output (366) and including a second control terminal configured and arranged to receive the fourth local oscillator signal (270°); and
a third switch (346) coupled between the first node (334) and the third output (370) and including a third control terminal (90°) configured and arranged to receive the second local (90°) oscillator signal
further comprising;
a second capacitor (312) coupled between the second RF input (308) and a second node (336);
a fourth switch (320) coupled between the second node (336) and the first RF input (306) and including a fourth control terminal configured and arranged to receive the first local oscillator signal;
a fifth switch coupled (344) between the second node (336) and the second output (368) and including a fifth control terminal configured and arranged to receive the fourth local oscillator signal; and
a sixth switch coupled (348) between the second node (336) and the fourth output (372) and including a sixth control terminal configured and arranged to receive the second local oscillator signal;
further comprising:
a third capacitor (314) coupled between the first RF input (306) and a third node (338);
a seventh switch (322) coupled between the third node (338) and the second RF input and including a seventh control terminal configured and arranged to receive the second local oscillator signal;
an eighth switch (352) coupled between the third node (338) and the second output (368) and including an eighth control terminal configured and arranged to receive the first local oscillator signal; and
a ninth switch coupled (356) between the third node (338) and the fourth output (372) and including a ninth control terminal configured and arranged to receive the third local oscillator signal; and
further comprising:
a fourth capacitor (316) coupled between the second RF input (308) and a fourth node (340);
a tenth switch (324) coupled between the fourth node (340) and the first RF input (306) and including a tenth control terminal configured and arranged to receive the second local oscillator signal;
an eleventh switch (350) coupled between the fourth node (340) and the first output (336) and including an eleventh control terminal configured and arranged to receive the first local oscillator signal; and
a twelfth switch (354) coupled between the fourth node (340) and the third output and including a twelfth control terminal configured and arranged to receive the third local oscillator signal.

2. The subharmonic mixer of claim 1, wherein the first phase is nominally 90 degrees offset from the second phase and the second phase is nominally 180 degrees offset from the fourth phase.

3. The subharmonic mixer of claim 2, wherein the subharmonic mixer is configured and arranged to receive RF signals, each having a second frequency, at the first and second RF inputs, wherein the first frequency is less than the second frequency.

4. The subharmonic mixer of claim 3, wherein the first frequency is nominally half the second frequency.

5. The subharmonic mixer of any preceding claim, further comprising:
a thirteenth switch coupled in parallel with the first switch and including a thirteenth control terminal configured and arranged to receive the third local oscillator signal;
a fourteenth switch coupled in parallel with the fourth switch and including a fourteenth control terminal configured and arranged to receive the third local oscillator signal;
a fifteenth switch coupled in parallel with the seventh switch and including a fifteenth control terminal configured and arranged to receive the fourth local oscillator signal; and
a sixteenth switch coupled in parallel with the tenth switch and including a sixteenth control terminal configured and arranged to receive the fourth local oscillator signal.

6. The subharmonic mixer of any preceding claim, further comprising:
a plurality of baseband capacitors (358, 360, 362, 364), each coupled between a reference node and a respective output of the first, second, third, and fourth outputs.

7. The subharmonic mixer of any preceding claim, wherein the first and second RF inputs are configured and arranged to receive first and second differential RF inputs signals.

8. The subharmonic mixer of 7 claim, wherein the first and second differential RF signals each have a frequency within +/- 5% of 80 GHz.

9. The subharmonic mixer of any preceding claim, wherein the first frequency is within +/-5% of 40 GHz.

10. The subharmonic mixer of claim 7, wherein the first and second differential RF signals have a frequency which is four times the first frequency.

11. A system comprising:
transmitter circuitry comprising:
a signal generator configured to generate a signal; and
local oscillator circuitry coupled to the signal generator and configured to generate, based on the signal, a first local oscillator signal having the first frequency and the first phase, a second local oscillator signal having the first frequency and the second phase, a third local oscillator signal having the first frequency and the third phase, and a fourth local oscillator signal having the first frequency and the fourth phase; and
receiver circuitry comprising:
an antenna; and
a subharmonic mixer as claimed in any preceding claim.

12. The system of claim 11, wherein the first phase is nominally 90 degrees offset from the second phase and the second phase is nominally 180 degrees offset from the fourth phase.

13. The system of claim 12, wherein the transmitter circuitry is configured to transmit radar signals, each at the second frequency, based on signals generated by the signal generator, wherein the first frequency is less than the second frequency.

14. The system of claim 13, wherein the first and second inputs are configured and arranged to receive differential RF inputs signals having the second frequency and corresponding to reflections of the radar signals transmitted by the transmitter circuitry, wherein the reflections are received at the antenna of the receiver circuitry.

15. The system of claim 14, wherein the first frequency is nominally half the second frequency.
